# EUROPÄISCHE PATENTSCHRIFT

(11) **EP 0 608 681 B1**
(45) Veröffentlichungstag und Bekanntmachung des Hinweises auf die Patenterteilung: **23.04.1997**
(21) Anmeldenummer: 94100070.5
(22) Anmeldetag: 04.01.1994
(51) Int. Cl.: H03L 1/02

(54) **Oszillatorschaltung mit einem die Schwingquarzindividuellen Kenninformationen speichernden Speicher**
Oscillator circuit with a memory for memorising characteristic information individual to the quartz vibrator
Circuit, oscillateur avec une mémoire de mémorisation d'informations caractéristiques individuelles au quartz vibreur

(30) Priorität: 29.01.1993 DE 4302542
(43) Veröffentlichungstag der Anmeldung: 03.08.1994
(73) Patentinhaber: SIEMENS AKTIENGESELLSCHAFT, 80333 München (DE)
(72) Erfinder: Zwack, Eduard, D-82178 Puchheim (DE)

(56) Entgegenhaltungen:
- EP-A- 0 283 529
- EP-A- 0 310 863
- FR-A- 2 469 823
- US-A- 5 081 431

## Beschreibung

In taktgesteuerten, insbesondere nachrichtentechischen Einrichtungen sind aufgrund erhöhter Stabilitäts- und Sicherheitsanforderungen Oszillatorschaltungen überwiegend mit Schwingquarzen realisiert. Die Schwingquarze weisen in Abhängigkeit von den Quarzschnitten unterschiedliche temperaturabhängige Resonanzfrequenzen auf. Die Temperaturabhängigkeit ist durch eine schwingquarzindividuelle Temperaturkennlinie bzw. Kenninformation definiert, die bei der Quarzherstellung ermittelt bzw. gemessen wird. Diese temperaturbezogenen und weitere schwingquarzindividuelle Kenninformationen - z.B. Änderung der Schwingquarzeigenschaften aufgrund der Alterung des Schwingquarzes - werden den Anwendern von Schwingquarzen - insbesondere in Oszillatorschaltungen - auf Datenblättern oder für jeden Quarz separat druckschriftlich mitgeteilt. Desweiteren sind Aufdrucke auf den Schwingquarzen bekannt, anhand derer die schwingquarzindividuellen Kenninformationen aus Datenblättern entnehmbar sind. Bevorzugt werden die Schwingquarze in Oszillatorschaltungen eingesetzt, in denen digitale Taktsignale mit einer durch den Schwingquarz vorgegebenen Frequenz gebildet werden. Durch die individuellen Eigenschaften der Schwingquarze müssen in den die digitale Taktsignale verarbeitenden und an die Oszillatorschaltung angeschlossenen Takteinrichtungen - insbesondere in phasenregelkreisgesteuerten Takteinrichtungen - für hochgenaue Taktsteuerungen die schwingquarzindividuellen Kenninformationen verfügbar sein. Da zunehmend in den Takteinrichtungen durch Programme realisierte Taktsteuerungsverfahren vorgesehen sind, erfolgt die Eingabe der schwingquarzindividuellen Kenninformationen der zugeordneten Oszillatorschaltung für jede Taktsteuerung separat. Dies bedeutet einen erheblichen zusätzlichen Aufwand bei der Zuordnung einer Oszillatorschaltung zu einer Takteinrichtung bzw. zu einer Einrichtung, in der eine hochpräzise Verarbeitung der Taktsignale stattfindet und in der folglich die schwingquarzindividuellen Kenninformationen einzubringen sind.

Der Erfindung liegt daher die Aufgabe zugrunde, diesen erheblichen Aufwand für das Einbringen der schwingquarzindividuellen Kenninformationen in die an die jeweilige Oszillatorschaltung angeschlossene weiterverarbeitende Einrichtung zu reduzieren. Die Aufgabe wird ausgehend von einer Oszillatorschaltung gemäß dem Oberbegriff des Anspruchs 1 durch dessen kennzeichnende Merkmale gelöst.

Der wesentliche Aspekt der erfindungsgemäßen Oszillatorschaltung ist darin zu sehen, daß in dieser ein die schwingquarzindividuellen Informationen speicherndes Mittel angeordnet und derart ausgestaltet ist, daß die schwingwquarzindividuellen Kenninformationen als analoge, digitale, codierte digitale Signale oder modulierte Signale an einen Ausgang der Oszillatorschaltung gesteuert werden. Die schwingquarzindividuellen Informationen werden hierbei vorzugsweise beim Herstellen der Oszillatorschaltung eingespeichert. Der wesentliche Vorteil der erfindungsgemäßen Oszillatorschaltung ist darin zu sehen, daß nach einem einmaligen Einspeichern der schwingquarzindividuellen Kenninformationen diese Kenninformation ständig an einem Ausgang der Oszillatorschaltung den weiterverarbeitenden Einrichtungen zur Verfügung stehen und somit bei Anschluß oder Wechsel einer weiterverarbeitenden Einrichtung nicht mehr durch aufwendiges Einspeichern eingebracht werden müssen.

Besonders vorteilhaft wird bei einem Bilden von digitalen Taktsignalen in der Oszillatorschaltung das die schwingquarzindividuellen Kenninformationen speichernde Mittel durch ein Mittel zur Beeinflussung der Taksignale realisiert - Anspruch 2. Hierbei werden die schwingquarzindividuellen Kenninformationen zusammen mit den Taktsignalen an den bereits vorhandenen Ausgang für die Taktsignale geführt, wobei die Taktsignale in Abhängigkeit von den gespeicherten schwingquarzindividuellen Kenninformationen beeinflußt werden. Diese Möglichkeit der Beeinflussung ist des weiteren für Taktsignale möglich, die in einem in der Oszillatorschaltung angeordneten Meßoszillator gebildet werden - Anspruch 3. Mit Hilfe des Meßoszillators wird die aktuelle Temperatur der Oszillatorschaltung gemessen und die gebildeten Meßsignale - vorzugsweise digitale Meßsignale - werden über einen Meßausgang der Oszillatorschaltung an weiterverarbeitende Einrichtungen geführt. Die wesentlichen Eigenschaften einer Temperaturoszillatorschaltung sind darin zu sehen, daß Temperaturänderungen möglichst hohe Frequenzänderungen der gebildeten Meßsignale hervorrufen.

Eine wesentliche schwingquarzindividuelle Kenninformation stellt die Temperaturkennlinie eines Schwingquarzes dar, wobei die Temperaturkennlinien die Resonanzfrequenzen des jeweiligen Schwingquarzes in Abhängigkeit von der Umgebungstemperatur angeben. Um den Umfang der schwingquarzindividuellen Kenninformationen zu begrenzen, wird einer schwingquarzindividuellen Kenninformation eine Gruppe von Temperaturkennlinien zugeordnet - Anspruch 5. Die Größe der zugeordneten Gruppe von Temperaturkennlinien ist hierbei auf die geforderte Genauigkeit an die Frequenzstabilität der gebildeten Taktsignale abzustimmen. Dies bedeutet, daß bei steigenden Genauigkeitsanforderungen die Anzahl der Temperaturkennlinien je Gruppe zu vermindern ist.

Gemäß einer vorteilhaften Ausgestaltung der Oszillatorschaltung sind die Mittel zur Beeinflussung der Taktsignale oder Meßsignale
- durch eine die Signalpulsdauer- bzw. Pulspause modulierende Modulationseinrichtung, oder
- durch eine die Signalfrequenz vorgegeben ändernde Frequenzeinstelleinrichtung, oder
- durch eine den Signalpegel variierende Pegeleinrichtung, oder
- durch eine die Impedanz des Ausgangs der Oszillatorschaltung variierende Impendanzeinrichtung realisiert
   - Anspruch 6.

Eine besonders vorteilhafte Variante stellt hierbei die Pulsdauer- bzw. Pulspausenmodulation der Taktsignale bzw. der Meßsignale dar, da hierbei durch Zusammenfassen mehrerer Taktsignale bzw. Meßsignale eine codierte, beliebig umfangreiche Information gebildet und an eine weiterverarbeitende Einrichtung übermittelbar ist. Die Beeinflussung der Taktsignale bzw. Meßsignale wird hierbei durch bekannte Modulationseinrichtungen, Frequenzeinstelleinrichtungen, Pegeleinrichtungen und Impedanzeinrichtungen realisiert.

Die Mittel zur Speicherung der schwingquarzindividuellen Kenninformationen bzw. Temperaturkennlinien-Information sind vorteilhaft durch einstellbare, eine digitale Information bildende Einstellmittel oder programmierbare Speichermittel realisiert - Anspruch 7. Die Einstellmittel sind beispielsweise durch Schaltelemente oder Codierschaltelemente gebildet, die beim Herstellen einer Oszillatorschaltung, d.h. bei der Fertigung eines Taktksignale erzeugenden Taktoszillators, entsprechend der aktuell gemessenen Temperaturkennlinie des Schwingqzuarzes eingestellt werden. Alternativ hierzu kann die Temperaturkennlinien-Information in einen in der Oszillatorschaltung angeordneten programmierbaren Speicher der Oszillatorschaltung einmalig eingespeichert werden. Diese Einspeicherung ist nur bei einem Wechsel des Schwingquarzes in der jeweiligen Oszillatorschaltung zu ändern.

Für eine Bewertung bzw. Auswertung der modifizierten bzw. beeinflußten Takt- oder Meßsignale ist in einer an den Ausgang bzw. den Meßausgang der Oszillatorschaltung angeschlossene weiterverarbeitende Einrichtung ein Mittel zum Erkennen und Bewerten der modifizierten bzw. beeinflußten Takt- oder Meßsignale angeordnet und derart ausgestaltet, daß die schwingquarzindividuellen Informationen aus dem zugeführten modifizierten bzw. beeinflußten Takt- bzw. Meßsignal abgeleitet werden können - Anspruch 8. Analog zu den Mitteln zur Beeinflussung der Taktsignale oder Meßsignale sind in den weiterverarbeitenden Einrichtungen die Mittel zum Erkennen und Bewerten der modifizierten Taktsignale durch eine die Pulsdauer- bzw. die pulspausenmodulierten Takt- bzw. Meßsignale demodulierende Demodulationseinrichtung, durch eine die vorgegeben geänderte Taktsignal- bzw. Meßsignalfrequenz erkennende Frequenzmeßeinrichtung, oder durch eine den Pegel der Taktsignale bzw. Meßsignale oder die Impedanz des Ausgangs oder Meßausgangs der Oszillatorschaltung messende Pegelmeßeinrichtung bzw. Impedanzmeßeinrichtung realisiert - Anspruch 9. Besonders vorteilhaft ist in mikroprozessorgesteuerten, die digitale Signale weiterverarbeitenden Einrichtungen eine die Pulsdauer- bzw. pulspausenmodulierten Takt-bzw. Meßsignale demodulierende Demodulationseinrichtung realisierbar, da bei einem durch mehrere Taktsignale bzw. Meßsignale gebildete Impulstelegramm jedem Taktsignal lediglich zwei Informationszustände zugeordnet und damit auf eine digitale Informationsverarbeitung bzw. Weiterverarbeitung abgestimmt sind.

Im folgenden wird die Erfindung anhand von Zeichnungen näher erläutert. Dabei zeigen
- Figur 1: ein Blockschaltbild eines Phasenregelkreises, und
- Figur 2: ein Diagramm, in dem Temperaturkennlinien von Quarzen mit "AT-Schnitt" dargestellt sind.

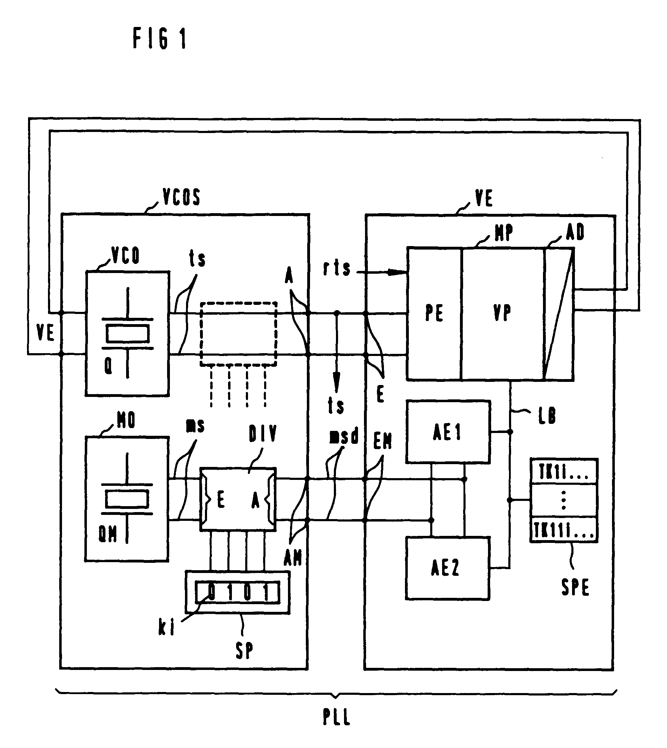

Figur 1 zeigt einen Phasenregelkreis PLL, der durch eine spannungsgesteuerte Oszillatorschaltung VCOS und eine Verarbeitungseinrichtung VE gebildet ist. Die Funktion eines Phasenregelkreises PLL ist darin zu sehen, die in der spannungsgesteuerten Oszillatorschaltung VCOS gebildeten Taktsignale ts phasensynchron zu an den Phasenregelkreis PLL geführten Referenztaktsignalen rts zu regeln. Der Phasenregelkreis PLL ist beispielsweise in der zentralen Takteinrichtung eines Kommunikationssystems angeordnet, wobei die gebildeten Taktsignale ts synchron zu ankommenden Referenztaktsignalen rts einer übergeordneten Takteinrichtung zu steuern sind.

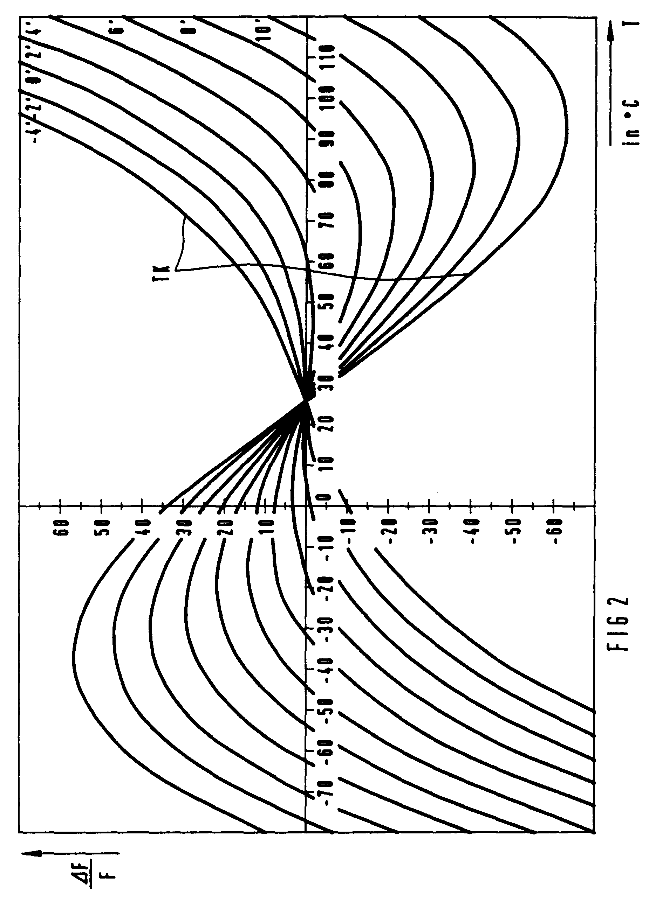

Für das Ausführungsbeispiel sei angenommen, daß die Spannungsgesteuerte Oszillatorschaltung VCOS einen die Taktsignale ts bildenden, spannungsgesteuerten Oszillator VCO sowie einen Meßsignale ms bildenden Meßoszillator MO aufweist. Die Taktsignalfrequenz der Taktsignale ts ist durch einen Schwingquarz Q bestimmt. Für das Ausführungsbeispiel sei angenommen, daß ein Schwingquarz Q mit "AT-Schnitt" eingesetzt wird. Derartige Schwingquarze Q weisen üblicherweise eine der in Figur 2 dargestellte Temperaturkennlinien TK auf. Die Temnperaturkennlinien TK sind in einem X/X-Koordinatensystem dargestellt, wobei auf der X-Achse die Temperaturänderungen T des Schwingquarzes Q in Grad Celsius und auf der Y-Achse die Resonanzfrequenzabweichungen F von der Resonanznennfrequenz F des Schwingquarzes angegeben sind.

In Fig. 2 repräsentiert jede dargestellte Temperaturkennlinie TK eine Gruppe von Temperaturkennlinien TK, die jeweils einer Umgebungstemperaturbereich von +/- 1 °C umfassen, wobei die Anzahl von Temperaturkennlinien TK bei kleinen Umgebungstemperaturstufen sehr groß wird und einen erheblichen Umfang an Kenninformationen bedeuten würde.

Für das Ausführungsbeispiel sei des weiteren angenommen, daß jeder Temperaturkennlinie TK eine Kenninformation ki zugeordnet ist. Dies bedeutet, daß für elf Temperaturkennlinien TK eines Schwingquarz Q mit "AT-Schnitt" elf Kenninformation ki vorgesehen sind. Neben diesen Temperaturkennlinien TK können weitere schwingwarzindividuelle Kenninformationen ki, wie z.B. eine durch die Alterung der Schwingquarze Q hervorgerufene Verschiebung der Temperaturkennlinien TK, zugeordnet werden. Mit Hilfe des in der spannungsgesteuerten Oszillatorschaltung VCOS angeordneten Meßoszillators MO wird die Temperatur in der spannungsgesteuerten Oszilltorschaltung VCOS gemessen. Hierzu wird im Meßoszillator MO ein Schwingquarz QM eingesetzt, bei dem Temperaturänderungen möglichst große Resonanzfrequenzabweichungen verursachen. Dies wird durch spezielle Meßschwingquarze mit anderen Quarzschnitten erreicht. Die im Meßoszilltor MO gebildeten Meßsignale ms werden an die Verarbeitungseinrichtung VE weitergeleitet, dort die Frequenzänderung festgestellt und daraus die Temperaturänderung berechnet. Für das Ausführungsbeispiel sei angenommen, daß diese Meßsignale ms erfindungsgemäß in Abhängigkeit von der Kenninformation ki des in der Oszillatorschaltung VCOS eingesetzten Schwingquarzes Q modifiziert bzw. beeinflußt werden. Dies wird dadurch erreicht, daß in der Oszillatorschaltung VCOS eine Dividiereinrichtung DIV angeordnet ist, an dessen Eingang E die Meßsignale ms gesteuert werden. Die Dividiereinrichtung DIV ist beispielsweise durch einen binären Zähler realisiert, dessen Zählrhythmus durch zugeführte binär codierte Informationen repräsentierende Kenninformationen ki einstellbar ist. Durch die Zählrhythmen wird der Divisor der Dividiereinrichtung DIV bestimmt. Bezogen auf die Figur 2 gemäßen Temperaturkennlinien TK sind elf Divisionsfaktoren erforderlich, um dem Meßsignal ms elf Temperaturkennlinien TK zuzuordnen. Die Zuordnung der Temperaturkennlinien TK, die der in der Oszillatorschaltung VCOS eingesetzte Schwingquarz Q aufweist, wird durch Eingeben der die jeweilige Temperaturkennlinie TK repräsentierende schwingquarzindividuelle Kenninformation ki in den Speicher SP erreicht. Der Speicher SP ist beispielsweise durch einen nichtflüchtigen, programmierbaren Speicher (PROM) oder durch vier Schaltelemente realisiert, da für elf Temperaturkennlinien TK vier Schaltelemente, mit deren Hilfe 2³ codierte Informationen gebildet werden können, ausreichen. Entsprechend der eingegegbenen codierten binären Information ki werden die Meßsignale ms entsprechend dem zugeordneten Divisor dividiert und über den Ausgang AM der Oszillatorschaltung VCOS an einen Eingang EM der Verarbeitungseinrichtung VE übermittelt. In der Verarbeitungseinrichtung VE werden die dividierten Meßsignale msd über entsprechende Verbindungen an eine erste und an eine zweite Auswerteeinheit AE1, AE2 übermittelt. In der ersten Auswerteeinheit AE1 werden die durch die Temperaturänderungen in der Oszillatorschaltung VCOS hervorgerufenen relativ kleinen Frequenzänderungen erkannt bzw. bewertet und das Bewertungsergebnis über einen lokalen Bus LB an eine Mikroprozessoreinrichtung MP übermittelt. In der zweiten Auswerteeinheit AE2 wird durch Frequenzmessung der durch die Kenninformation ki in der Dividiereinrichtung DIV bewirkte Divisor ermittelt, woraus die binär codierte Information ki sowie die Temperaturkennline TK des Schwingquarzes Q abgeleitet werden kann. Die Auswertung der digitalen, dividierten Meßsignale msd ist durch eine schaltungstechnisch und programmtechnisch realisierte zweite Auswerteeinrichtung AE2 möglich. Da die Verarbeitungseinrichtung VE üblicherweise einen Mikroprozessor MP aufweist, wird die erste und zweite Auswerteeinheit AE1, AE2 vorzugsweise per Programm im Mikroprozessor MP realisiert.

Die in der zweiten Auswerteeinheit AE2 abgeleitete Kenninformation ki wird über den lokalen Bus LB an die Mikroprozessoreinrichtung MP übermittelt. Mit Hilfe eines mikroprozessorgeeignetenProgrammes werden die in einem an den lokalen Bus LB angeschlossenen Speicher SPE hinterlegten, jeweiles eine Gruppe von Temperaturkennlinien Tk repräsentierenden Temperaturkennlinien-Informationen TK1 ... TK11 entsprechend der ermittelten Kenninformation ki ausgelesen und entsprechend weiterverarbeitet.

In der Verarbeitungseinrichtung VE ist des weiteren eine Phasenvergleichseinrichtung PE vorgesehen, an die die Referenztaktsignale rts und die Taktsignale ts übermittelt und hinsichtlich ihrer Phase verglichen werden. Die Phasenvergleichssignale werden an ein Verarbeitungsprogramm VP im Mikroprozessor MP übermittelt, dort phasenregelkreisgemäß aufbereitet und über einen Analog-Digital-Wandler AD an einen Spannungseingang VE der Oszillatorschaltung VCOS übermittelt.

Alternativ, - beispielsweise bei Fehlen eines Meßoszillators MO, ist die Dividiereinrichtung zwischen den Ausgang A der Oszillatorschaltung VCOS und dem Oszillator VCO einzufügen - ist strichliert dargestellt - . Hierbei ist zu beachten, daß in der Verarbeitungseinrichtung VE nach dem Feststellen des Divisors die Taktsignale ts entsprechend zu multiplizieren sind. Des weiteren können anstelle der Divisionseinrichtungen DIV die Taktsignale ts bzw. Meßsignale ms pulsdauer- oder pulspausen- modulierende Einrichtungen eingefügt werden. Diese Ausführungsvariante erhöht zwar den Aufwand der Oszillatorschaltung VCOS geringfügig, jedoch ist in der Verarbeitungseinrichtung VE eine weitgehende digitale Verarbeitung möglich, wodurch die Verarbeitungseinrichtung VE überwiegend in einem Mikroprozessor MP realisierbar ist.

## Patentansprüche

1. Oszillatorschaltung (VCOS) mit einem schwingquarzindividuelle Kenninformationen (ki) aufweisenden Schwingquarz (Q), wobei in der Oszillatorschaltung (VCOS) gebildete Wechselsignale (ts) an einen Ausgang (A) geführt werden,
**dadurch gekennzeichnet**,
daß in der Oszillatorschaltung ein die schwingquarzindividuellen Kenninformationen (ki) speicherndes Mittel derart ausgestaltet ist, daß die schwingquarzindividuellen Kenninformationen (ki) an zumindest einen Ausgang (A, AM) der Oszillatorschaltung (VCOS) als analoge, digitale, codierte digitale oder modulierte Signale (msd) gesteuert werden.

2. Oszillatorschaltung nach Anspruch 1,
**dadurch gekennzeichnet**,
daß die Oszillatorschaltung (VCOS) derart ausgestattet ist, daß digitale Taktsignale (ts) gebildet und an einen Taktsingalausgang (A) geführt werden, daß das die schwingquarzindividuellen Kenninformationen (ki) speichernde Mittel durch ein Mittel (DIV) zur Beeinflussung der Taktsignale (ts) realisiert und derart ausgestaltet ist, daß die gebildeten Taktsignale (ts) in Abhängigkeit von den gespeicherten, schwingquarzindividuellen Kenninformationen (ki) beeinflußt werden.

3. Oszillatorschaltung nach Anspruch 1 oder 2,
**dadurch gekennzeichnet**,
daß in der Oszillatorschaltung (VCOS) ein für eine Temperaturmessung der Oszillatorschaltung (VCOS) vorgesehene Meßoszillator (MO) angeordnet ist, wobei die gebildeten Meßsignale (ms) an einen Meßausgang (AM) der Oszillatorschaltung (VCOS) geführt werden, und daß das die schwingquarzindividuellen Kenninformationen (ki) speichernde Mittel durch ein Mittel (DIV) zur Beeinflussung der Meßsignale (ms) realsiert und derart ausgestaltet ist, daß die gebildeten Maßsignale (ms) in Abhängigkeit von den gespeicherten schwingquarzindividuellen Kenninformationen (ki) beeinflußt werden.

4. Oszillatorschaltung nach einem der vorhergehenden Ansprüche,
**dadurch gekennzeichnet**,
daß in dem die schwingquarzindividuellen Kenninformationen (ki) speichernden Mittel (SP) die die Temperaturkennlinie (TK) des jeweiligen Schwingquarzes (Q) repräsentierende Kenninformationen (Ki) gespeichert sind.

5. Oszillatorschaltung nach Anspruch 4,
**dadurch gekennzeichnet**,
daß den schwingquarzindividuellen Kenninformationen (ki) jeweils eine vorgegebene Gruppe von Temperaturkennlinien (TK) des jeweiligen Schwingquarzes (Q) zugeordnet ist.

6. Oszillatorschaltung nach einem der vorhergehenden Ansprüche,
**dadurch gekennzeichnet**,
daß die Mittel zur Beeinflussung der Taktsignale (ts) oder Meßsignale (ms) durch
- eine die Signalpulsdauer- bzw. Pulspause modulierende Modulationseinrichtung oder
- durch eine die Signalfrequenz vorgegeben ändernde Frequenzeinstelleinrichtung (DIV), oder
- durch eine den Signalpegel variierende Pegeleinrichtung,
- oder durch eine die Impedanz des Ausgangs (A) bzw. Meßausgangs (AM) der Oszillatorschaltung (VCOS) variierende Impendanzeinrichtung realisiert sind.

7. Oszillatorschaltung nach einem der vorhergehenden Ansprüche,
**dadurch gekennzeichnet**,
daß die Mittel zur Speicherung der schwingquarzindividuellen Kenninformationen (ki) durch einstellbare, eine digitale Information bildende Einstellmittel oder programmierbare Speichermittel realisiert sind, wobei die digitalen, codierten Informationen die schwingquarzindividuellen Kenninformoramtionen (ki) repräsentieren und die Mittel (DIV) zur Beeinflussung der Takt- bzw. Meßsignale (ts, ms) steuern.

8. Oszillatorschaltung nach einem der vorhergehenden Ansprüche,
**dadurch gekennzeichnet**,
daß in einer an einen die Taktsignale (ts) oder die Meßsignale (ms) bereitstellenden Ausgang (A, AM) der Oszillatorschaltung(VCOS) angeschlossenen, die Takt- bzw. Meßsignale (ts, ms) weiterverarbeitenden Takteinrichtung (VE) ein Mittel (AE2) zum Erkennen und Bewerten der beeinflußten Takt-oder Meßsignale (ts, ms) angeordnet und derart ausgestaltet ist, daß die schwingquarzindividuellen Kenninformationen (ki) aus den zugeführten, beeinflußten Takt- bzw. Meßsignalen (ts, ms) abgleitet werden.

9. Oszillatorschaltung nach Anspruch 7,
**dadurch gekennzeichnet**,
daß die Mittel zum Erkennen und Bewerten der modifizierten Takt- oder Meßsignale (ts, ms) durch
- eine die pulsdauer- bzw. pulspausenmodulierten Takt- bzw. Meßsignale (ts, ms) demodulierende Demodulationseinrichtung,
- eine die vorgegebenen, geänderte Taktsignal- bzw. Meßsignalfrequenz erkennende Frequenzdetektionseinrichtung (AE2) oder
- durch eine den Pegel der Taktsignale bzw. Meßsignale (ts, ms) messende Pegelmeßeinrichtung,
- oder durch eine die Impedanz des Ausgangs (A) oder Meßausgangs (AM) der Oszillatorschaltung (VCOS) messende Impedanzmeßeinrichtung realisiert sind.

## Claims

1. Oscillator circuit (VCOS) having a quartz crystal oscillator (Q) having characteristic information (ki) specific to the quartz crystal oscillator, alternating signals (ts) formed in the oscillator circuit (VCOS) being led to an output (A), characterized in that means storing an item (ki) of characteristic information specific to the quartz crystal oscillator are configured in such a way in the oscillator circuit that the characteristic information (ki) specific to the quartz crystal oscillator is directed to at least one output (A, AM) of the oscillator circuit (VCOS) as analogue, digital, coded digital or modulated signals (msd).

2. Oscillator circuit according to Claim 1, characterized in that the oscillator circuit (VCOS) is configured such that digital clock signals (ts) are formed and led to a clock signal output (A), in that the means storing the characteristic information (ki) specific to the quartz crystal oscillator are implemented by means (DIV) for influencing the clock signals (ts) and are configured such that the clock signals (ts) formed are influenced as a function of the stored characteristic information (ki) specific to the quartz crystal oscillator.

3. Oscillator circuit according to Claim 1 or 2, characterized in that a measuring oscillator (MO) provided for temperature measurement of the oscillator circuit (VCOS) is arranged in the oscillator circuit (VCOS), the measurement signals (ms) formed being led to a measuring output (AM) of the oscillator circuit (VCOS) and in that the means storing the characteristic information (ki) specific to the quartz crystal oscillator are implemented by means (DIV) for influencing the measurement signals (ms) and are configured such that the measurement signals (ms) formed are influenced as a function of the stored characteristic information (ki) specific to the quartz crystal oscillator.

4. Oscillator circuit according to one of the preceding claims, characterized in that the characteristic information (ki) representing the temperature characteristic (TK) of the respective quartz crystal oscillator (Q) is stored in the means (SP) storing the characteristic information (ki) specific to the quartz crystal oscillator.

5. Oscillator circuit according to Claim 4, characterized in that the characteristic information (ki) specific to the quartz crystal oscillator is respectively assigned a prescribed group of temperature characteristics (TK) of the respective quartz crystal oscillator (Q).

6. Oscillator circuit according to one of the preceding claims, characterized in that the means for influencing the clock signals (ts) or measurement signals (ms) are implemented by
- a modulation device modulating the signal pulse duration or pulse pause, or
- by a frequency-setting device (DIV) which changes the signal frequency in a prescribed manner, or
- a level device which varies the signal level,
- or by an impedance device which varies the impedance of the output (A) or measuring output (AM) of the oscillator circuit (VCOS).

7. Oscillator circuit according to one of the preceding claims, characterized in that the means for storing the characteristic information (ki) specific to the quartz crystal oscillator are implemented by adjustable setting means which form digital information, or by programmable storage means, the digital, coded information representing the characteristic information (ki) specific to the quartz crystal oscillator and controlling the means (DIV) for influencing the clock and measurement signals (ts, ms), respectively.

8. Oscillator circuit according to one of the preceding claims, characterized in that means (AE2) for detecting and evaluating the influenced clock or measurement signals (ts, ms), respectively, are arranged in a clock device (VE), which is connected to an output (A, AM), providing the clock signals (ts) or the measurement signals (ms), of the oscillator circuit (VCOS) and further processes the clock and measurement signals (ts, ms) respectively, and are configured in such a way that the characteristic information (ki) specific to the quartz crystal oscillator is derived from the clock and measurement signals (ts, ms), respectively, which have been fed and influenced.

9. Oscillator circuit according to Claim 7, characterized in that the means for detecting and evaluating the modified clock or measurement signals (ts, ms) are implemented by
- a demodulation device which demodulates the pulse-duration or pulse-pause modulated clock or measurement signals (ts, ms) respectively
- a frequency-detection device (AE2) which detects the prescribed, changed clock-signal or measuring-signal frequency or
- by a level-measuring device which measures the level of the clock signals or measurement signals (ts, ms) respectively,
- or by an impedance-measuring device which measures the impedance of the output (A) or measuring output (AM) of the oscillator circuit (VCOS).

## Revendications

1. Circuit oscillateur (VCOS) comportant un quartz oscillateur (Q) présentant des informations caractéristiques (ki) propres au quartz oscillateur, des signaux alternatifs (ts) formés dans le circuit oscillateur (VCOS) étant envoyés à une sortie (A),
caractérisé par le fait que
des moyens mémorisant les informations caractéristiques (ki) propres au quartz oscillateur sont conçus dans le circuit oscillateur de telle sorte que les informations caractéristiques (ki) propres au quartz oscillateur soient appliquées au moins à une sortie (A, AM) du circuit oscillateur (VCOS) en tant que signaux (msd) analogiques, numériques, numériques codés ou modulés.

2. Circuit oscillateur selon la revendication 1,
caractérisé par le fait que
le circuit oscillateur (VCOS) est conçu de telle sorte que des signaux numériques de cadence (ts) soient formés et soient envoyés à une sortie de signal de cadence (A), que les moyens mémorisant les informations caractéristiques (ki) propres au quartz oscillateur sont mis en oeuvre par des moyens (DIV) destinés à influencer les signaux de cadence (ts) et sont conçus de telle sorte que les signaux de cadence (ts) formés sont influencés en fonction des informations caractéristiques (ki) propres au quartz oscillateur et mémorisées.

3. Circuit oscillateur selon la revendication 1 ou 2,
caractérisé par le fait que
un oscillateur de mesure (MO) prévu pour une mesure de la température du circuit oscillateur (VCOS) est agencé dans le circuit oscillateur (VCOS), les signaux de mesure (ms) formés étant envoyés à une sortie de mesure (AM) du circuit oscillateur (VCOS), et les moyens mémorisant les informations caractéristiques (ki) propres au quartz oscillateur sont mis en oeuvre par des moyens (DIV) destinés à influencer les signaux de mesure (ms) et sont conçus de telle sorte que les signaux de mesure (ms) formés soient influencés en fonction des informations caractéristiques (ki) propres au quartz oscillateur et mémorisées.

4. Circuit oscillateur selon l'une des revendications précédentes,
caractérisé par le fait que
les informations caractéristiques (ki) représentant la courbe caractéristique de température (TK) du quartz oscillateur (Q) concerné sont mémorisées dans les moyens (SP) mémorisant les informations caractéristiques (ki) propres au quartz oscillateur.

5. Circuit oscillateur selon la revendication 4,
caractérisé par le fait que
un groupe prédéterminé de courbes caractéristiques de température (TK) du quartz oscillateur (Q) concerné est associé aux informations caractéristiques (ki) propres au quartz oscillateur.

6. Circuit oscillateur selon l'une des revendications précédentes,
caractérisé par le fait que
les moyens destinés à influencer les signaux de cadence (ts) ou les signaux de mesure (ms) sont mis en oeuvre
- par un dispositif de modulation modulant la largeur d'impulsion du signal ou l'intervalle entre impulsions, ou
- par un dispositif de réglage de fréquence (DIV) modifiant de manière prescrite la fréquence du signal, ou
- par un dispositif de niveau modifiant le niveau du signal,
- ou par un dispositif d'impédance modifiant l'impédance de la sortie (A) ou de la sortie de mesure (AM) du circuit oscillateur (VCOS).

7. Circuit oscillateur selon l'une des revendications précédentes,
caractérisé par le fait que
les moyens destinés à la mémorisation des informations caractéristiques (ki) propres au quartz oscillateur sont mis en oeuvre par des moyens de réglage réglables et formant une information numérique ou par des moyens programmables de mémorisation, les informations numériques codées représentant les informations caractéristiques (ki) propres au quartz oscillateur et commandant les moyens (DIV) destinés à influencer les signaux de cadence ou de mesure (ts, ms).

8. Circuit oscillateur selon l'une des revendications précédentes,
caractérisé par le fait que
des moyens (AE2) destinés à identifier et évaluer les signaux de cadence ou de mesure (ts, ms) influencés sont agencés dans un dispositif (VE) de cadence, qui est raccordé à une sortie (A, AM), fournissant les signaux de cadence (ts) ou les signaux de mesure (ms), du circuit oscillateur (VCOS) et qui effectue un traitement ultérieur des signaux de cadence ou de mesure (ts, ms) et ces moyens sont conçus de telle sorte que les informations caractéristiques (ki) propres au quartz oscillateur sont déduites des signaux de cadence ou de mesure (ts, ms) influencés qui sont envoyés.

9. Circuit oscillateur selon la revendication 7,
caractérisé par le fait que
les moyens destinés à identifier et évaluer les signaux de cadence ou de mesure (ts, ms) modifiés sont mis en oeuvre
- par un dispositif de démodulation démodulant les signaux de cadence ou de mesure (ts, ms) modulés en largeur d'impulsions ou en intervalle entre impulsions,
- par un dispositif de détection de fréquence (AE2) identifiant de manière prescrite la fréquence modifiée du signal de cadence ou du signal de mesure, ou
- par un dispositif de mesure de niveau mesurant le niveau des signaux de cadence (ts) ou des signaux de mesure (ms),
- ou par un dispositif de mesure d'impédance mesurant l'impédance de la sortie (A) ou de la sortie de mesure (AM) du circuit oscillateur (VCOS).
